# EUROPEAN PATENT SPECIFICATION

(11) **EP 2 202 475 B1**
(45) Date of publication and mention of the grant of the patent: **02.05.2012**
(21) Application number: 08172731.5
(22) Date of filing: 23.12.2008
(51) Int. Cl.: F28F 3/02, H01L 23/367

(54) **Wing-spanning thermal-dissipating device**
Flügelumspannende Wärmeableitungsvorrichtung
Dispositif de dissipation thermique en forme d'aile

(43) Date of publication of application: 30.06.2010
(73) Proprietor: Kuo, Ching-Sung, Taipei County 236 (TW)
(72) Inventor: Kuo, Ching-Sung, Taipei County 236 (TW)
(74) Representative: 2K Patentanwälte Blasberg Kewitz & Reichel

(56) References cited:
- WO-A-79/00766
- WO-A-2007/102710
- JP-A- 10 065 076
- US-A1- 2001 010 264
- US-A1- 2002 043 360
- US-A1- 2004 000 393
- US-A1- 2004 264 134
- US-B1- 6 575 231

## Description

### BACKGROUND OF THE INVENTION

### Field of Invention

The invention relates to a thennal-dissipating device and, in particular, to a wing-spanning thermal-dissipating device.

### Related Art

Recently, the electronic products usually have high performance, high operating frequencies, high speeds, and more compact sizes. However, they also generate more heat that may result in instability of the electronic products. The instability can affect the reliability and lifetime of the electronic products. Therefore, heat dissipation has become an important issue of electronic products. Thermal-dissipating fins are commonly used in a thermal-dissipating device. How to improve the thermal-dissipating fins to enhance the thermal-dissipating efficiency is an important topic of the field.

A conventional win-spanning thermal-dissipating device has a plurality of thermal-dissipating sheets connecting with each other. Each of the thermal-dissipating sheets has a connecting portion and a thermal-dissipating fin. The thermal-dissipating fin is extended outwardly from one side of the connecting portion. During the assembly, the thermal-dissipating sheets are connected side by side and then spread out from each other so as to form a wing-spanning thermal-dissipating device. Thus, there is a space between the thermal-dissipating fins of the thermal-dissipating sheet. When the connecting portion of the wing-spanning thermal-dissipating device is in touch with a heat source, the heat can be transferred via the connecting portion to the thermal-dissipating fins. The air conduction and convection can then help to remove the heat.

Since the wing-spanning thermal-dissipating device relies upon air conduction and convection to remove heat, the thermal-dissipating effect is better if the contact area between the thermal-dissipating fins and air is larger. However, the contact area in the conventional wing-spanning thermal-dissipating device is restricted by the internal space of the electronic products. Therefore, it is difficult to increase the thermal-dissipating effect. This is particularly a problem for high-frequency electronic devices.

US 2001/010264 A1 discloses a heat dissipating device according to the preamble of claim 1, which includes a plurality of heat dissipating plates. Each of the heat dissipating plates has a stack plate portion and at least one fin plate portion that extends integrally from the stack plate portion. The fin plate portions of the heat dissipating plates arc bent from the stack plate portions to extend divergingly away from the stack part. The fin plate portions have confronting surfaces which diverge away from one another.

US 6,575,231 B1 discloses a heat dissipating module comprising a plurality of heat dissipating plates, formed by stamping, that arc axially stacked over one another while being angularly rotated relative to one another to form a spiral and stepped shape.

WO 2007/102710 A1 discloses a heat-sink device of a generally cylindrical geometry, comprising thermal-dissipating fins extending in radial direction.

US 2002/043360 A1 discloses a heatsink for dissipating heat from an electronic component including heatsink plates bound together at a binding portion to form a heat-absorbing portion for contacting a heat-dissipating surface of the electronic component.

US 2004/0000393 A1 discloses another heatsink comprising thermal-dissipating fins each having a plurality sub-thermal-dissipating fins protruding perpendicular therefrom.

### SUMMARY OF INVENTION

It is an object of the present invention to provide an improved wing-spanning thermal-dissipating device that has an a larger contact area between the thermal-dissipating fins and air for enhancing the thermal-dissipating effect.

This problem is solved by the wing-spanning thermal-dissipating device according to claim 1. Further advantageous embodiments are the subject-matter of the dependent claims.

To achieve the above, the invention discloses a wing-spanning thermal-dissipating device has a plurality of thermal-dissipating sheets. Each of the thermal-dissipating sheets includes a connecting portion, at least one thermal-dissipating fin and a plurality of sub-thermal-dissipating fins. The connecting portions of the thermal-dissipating sheets connect with each other (are connected with each other). The thermal-dissipating fin is extended outwardly and spread out from the connecting portion. The sub-thermal-dissipating fins are extended from at least one side of the thermal-dissipating fin.

As mentioned above, the wing-spanning thermal-dissipating device of the invention has several sub-thermal-dissipating fins extended from the thermal-dissipating fins. In comparison with the related art, the sub-thermal-dissipating fins provided by the invention can increase the contact area between the thermal-dissipating fins and air, thereby enhancing the thermal-dissipating efficiency.

### BRIEF DESCRIPTION OF THE DRAWINGS

The invention will become more fully understood from the detailed description and accompanying drawings, which are given for illustration only, and thus are not limitative of the present invention, and wherein:

FIGS. 1A and 1B are schematic views of a wing-spanning thermal-dissipating device according to a first embodiment of the invention;

FIG. 2 is a schematic view of a wing-spanning thermal-dissipating device according to a second embodiment of the invention;

FIG. 3 is a schematic view of a wing-spanning thermal-dissipating device according to a third embodiment of the invention;

FIG. 4 is a schematic view of a wing-spanning thermal-dissipating device according to a fourth embodiment of the invention;

FIG. 5 is a schematic view of an alternative wing-spanning thermal-dissipating device according to an embodiment that does not form part of the invention;

FIG. 6 is a schematic view of a wing-spanning thermal-dissipating device according to a fifth embodiment of the invention;

FIG. 7 is a schematic view of a wing-spanning thermal-dissipating device according to a sixth embodiment of the invention;

FIG. 8 is a schematic view of a wing-spanning thermal-dissipating device according to a seventh embodiment of the invention; and

FIG. 9 is a side view of a wing-spanning thermal-dissipating device according to an eighth embodiment of the invention.

### DETAILED DESCRIPTION OF THE INVENTION

The present invention will be apparent from the following detailed description, which proceeds with reference to the accompanying drawings, wherein the same references relate to the same elements.

### First Embodiment: expanded on single side, same sheet, crossing sub-thermal-dissipating fins

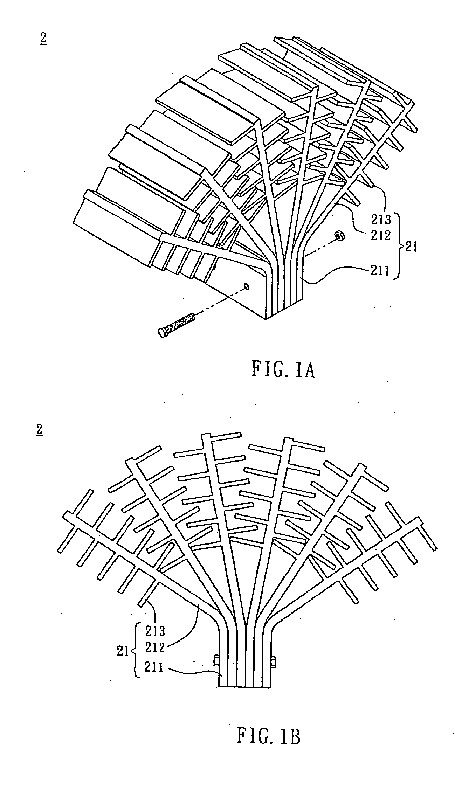

As shown in FIG. 1A and 1B, a wing-spanning thermal-dissipating device 2 has a plurality of thermal-dissipating sheets 21, which connect with each other. Each of the thermal-dissipating sheets 21 includes a connecting portion 211, a thermal-dissipating fin 212, and several sub-thermal-dissipating fins 213. The thermal-dissipating fin 212 is extended from the connecting portion 211 outwardly, and the thermal-dissipating fins 212 of each thermal-dissipating sheet 21 are spread out. The sub-thermal-dissipating fins 213 are extended outwardly from at least one side of the thermal-dissipating fin 212. In this embodiment, the sub-thermal-dissipating fins 213 are disposed perpendicular and asymmetrically on opposite sides of the thermal-dissipating fin 212, so that the sub-thennal-dissipating fins 213 and the adjacent thermal-dissipating fins 213 are disposed alternately. Of course, the sub-thermal-dissipating fins 213 can be disposed on the thermal-dissipating fin 212 in other ways. For example, they can be disposed non-perpendicular on opposite sides of the thermal-dissipating fin 212.

In this embodiment, each thermal-dissipating sheet 21 is integrally formed. The connecting portions 211 of the thermal-dissipating sheets 21 are connected by screws so as to form the wing-spanning thermal-dissipating device 2. The connecting portions 211 of the thermal-dissipating sheets 21 are disposed side by side. Alternatively, the thermal-dissipating sheets 21 can be connected by rivets.

In this embodiment, the thermal-dissipating sheets 21 can be completely different or the same. This embodiment does not restrict the shapes and sizes of the connecting portions 211, the thermal-dissipating fins 212, and the sub-thermal-dissipating fins 213. For example, the shapes or sizes of adjacent thermal-dissipating sheets 21 can be the same or different. In addition, the shapes or sizes of the thermal-dissipating fins 212 of adjacent thermal-dissipating sheets 21 can be the same or different as well. The technical importance of the embodiment is in that: the sub-thennal-dissipating fins 213 are extended from the thermal-dissipating fin 212 to increase the contact area between the sheet-combined thermal-dissipating device 2 and air, thereby enhancing the thermal-dissipating efficiency.

The sub-thermal-dissipating fins 213 touch against the adjacent thermal-dissipating fins 212 during the assembly so that the thermal-dissipating fins 212 expand outwardly from each other.

### Second Embodiment: expanded on double sides, same sheet, crossing sub-thermal-dissipating fins

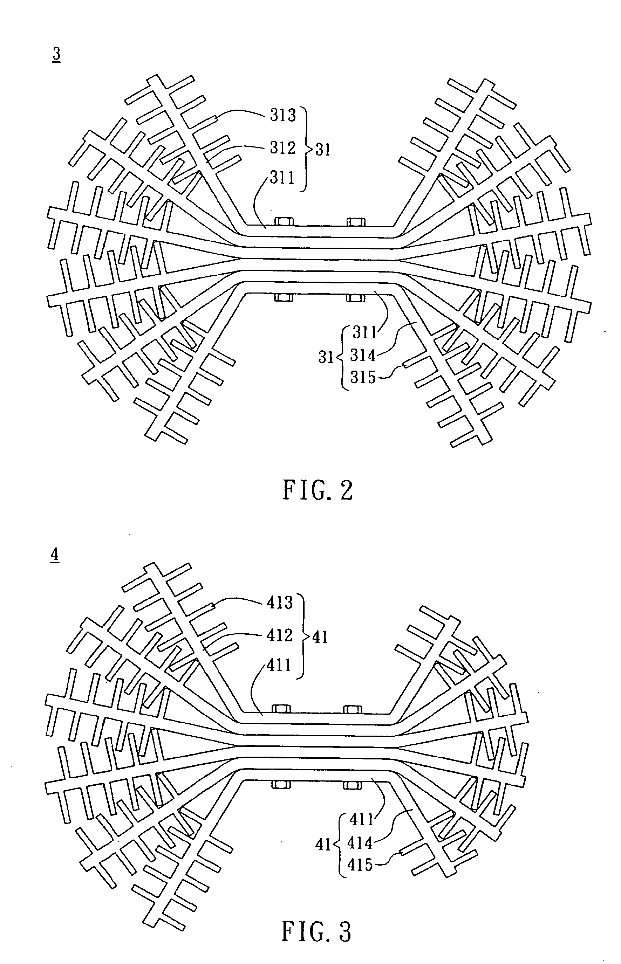

As shown in FIG. 2, a wing-spanning thermal-dissipating device 3 has a plurality of thermal-dissipating sheets 31, which connect with each other. Each thermal-dissipating sheet 31 includes a connecting portion 311, a thermal-dissipating fin 312, several sub-thermal-dissipating fins 313, a thermal-dissipating fin 314, and several sub-thermal-dissipating fins 315. The thermal-dissipating fins 312 and 314 are extended outwardly from different sides of the connecting portion 311. The sub-thermal-dissipating fins 313 and 315 are disposed asymmetrically and perpendicular on opposite sides of the thermal-dissipating fins 312 and 314. Having the thermal-dissipating fins 312 and 314 and the sub-thermal-dissipating fins 313 and 315 on both sides further enhances the thermal-dissipating efficiency.

### Third Embodiment: expanded on dual sides (with difference sizes), same sheet, crossing sub- thermal-dissipating fins

As shown in FIG. 3, a wing-spanning thermal-dissipating device 4 has a plurality of thermal-dissipating sheets 41, which connect with each other. Each thermal-dissipating sheet 41 includes a connecting portion 411, a thermal-dissipating fin 412, several sub-thermal-dissipating fins 413, a thermal-dissipating fin 414, and several sub-thermal-dissipating fins 415. The thermal-dissipating fin 414 is smaller than the thermal-dissipating fin 412. In addition, the sub-thermal-dissipating fins 413 and 415 are disposed perpendicular and asymmetrically on opposite sides of the thermal-dissipating fins 412 and 414. Having the thermal-dissipating fins 412 and 414 and the sub-thermal-dissipating fins 413 and 415 on both sides helps enhancing the thermal-dissipating efficiency.

### Fourth Embodiment: expanded on three sides, same sheet, crossing sub-thermal-dissipating fins

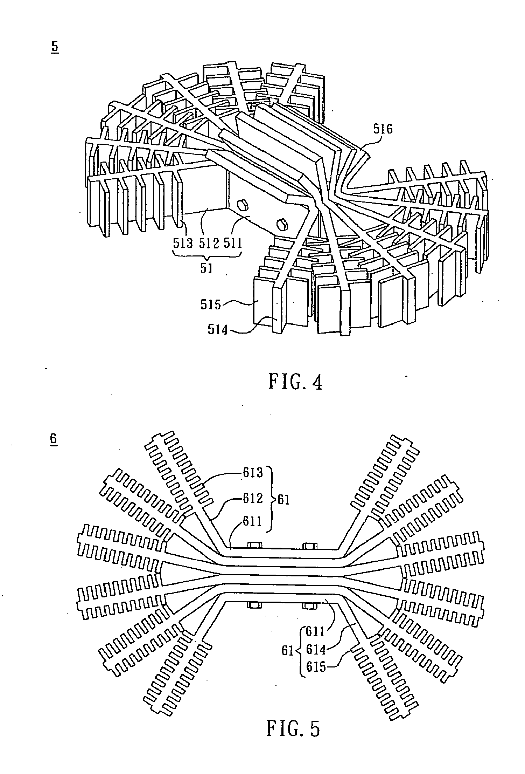

As shown in FIG. 4, a wing-spanning thermal-dissipating device 5 has a plurality of thermal-dissipating sheets 51, which connect with each other. Each thermal-dissipating sheet 51 includes a connecting portion 511, two thermal-dissipating fins 512 and 514, several sub-thermal-dissipating fins 513 and 515, and a thermal-dissipating part 516. The thermal-dissipating fins 512 and 514 and the thermal-dissipating part 516 are extended outwardly from different sides of the connecting portion 511. In this embodiment, the thermal-dissipating fins 512 and 514 and the thermal-dissipating part 516 are extended outwardly to the left, right and top of the connecting portion 511. In addition, the sub-thermal-dissipating fins 513 and 515 are disposed perpendicular and asymmetrically on opposite sides of the thermal-dissipating fins 512 and 514. Having the thermal-dissipating fins 512 and 514, the sub-thermal-dissipating fins 513 and 515, and the thermal-dissipating part 516 disposed along three directions can further enhance the thermal-dissipating efficiency.

### Alternative Embodiment that does not form part of the invention: expanded on double sides, same sheet, non-crossing sub-thermal-dissipating fins

As shown in FIG. 5, a wing-spanning thermal-dissipating device 6 in this embodiment has a plurality of thermal-dissipating sheets 61, which connect with each other. Each thermal-dissipating sheet 61 includes a connecting portion 611, a thermal-dissipating fin 612, several sub-thermal-dissipating fins 613, a thermal-dissipating fin 614, and several sub-thermal-dissipating fins 615. The thermal-dissipating fins 612 and 614 are extended outwardly from opposite sides of the connecting portion 611. In addition, the sub-thermal-dissipating fins 613 and 615 are disposed symmetrically and perpendicular on opposite sides of the thermal-dissipating fins 612 and 614. During the assembly, the sub-thermal-dissipating fins 613 and 615 touch against the adjacent sub-thermal-dissipating fins 613 and 615, so that the thermal-dissipating fins 611 expand outwardly. Having the thermal-dissipating fins 612 and 614 and the sub-thermal-dissipating fins 613 and 615 on both sides can further enhance the thermal-dissipating efficiency.

### Fifth Embodiment: expanded on double sides, same sheet, crossing sub-thermal-dissipating fins, bulging on outer side of thermal-dissipating_fins

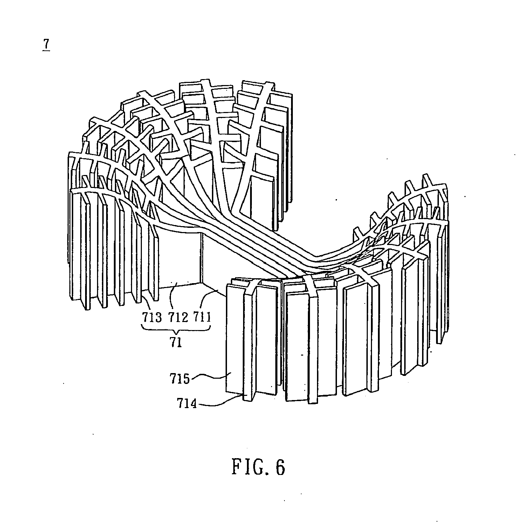

As shown in FIG. 6, a sheet-combined thermal-dissipating device 7 in this embodiment has a plurality of thermal-dissipating sheets 71, which connect with each other. Each thermal-dissipating sheet 71 includes a connecting portion 711, a thermal-dissipating fin 712, several sub-thermal-dissipating fins 713, a thermal-dissipating fin 714, and several sub-thermal-dissipating fins 715. The thermal-dissipating fins 712 and 714 are extended and bulging outwardly from different sides of the connecting portion 711. The height on the outer side of the thermal-dissipating fins 712 and 714 away from the connecting portion 711 is larger than that on the inner side near the connecting portion 711.

### Sixth Embodiment: expanded on single side, same sheet, thermal-dissipating sheet having air-channel portion

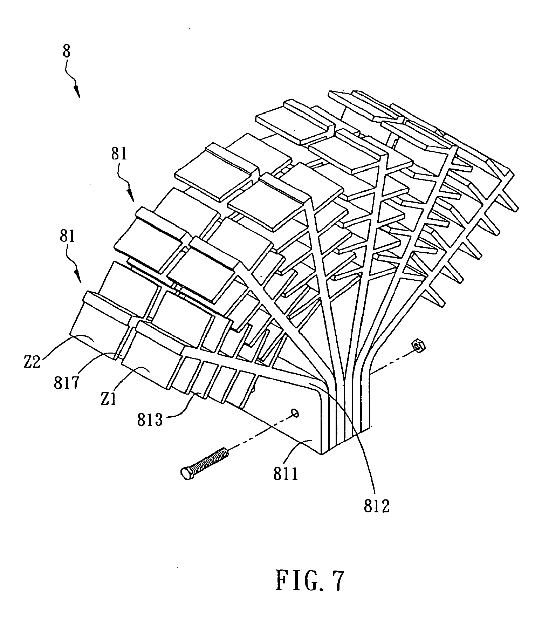

FIG. 7 is a schematic view of a wing-spanning thermal-dissipating device 8 according to the sixth embodiment of the invention. With reference to FIG. 7, the wing-spanning thermal-dissipating device 8 is made by connecting a plurality of thermal-dissipating sheets 81. Each of the thermal-dissipating sheets 81 includes a connecting portion 811, a thermal-dissipating fin 812 and a plurality of sub-thermal-dissipating fins 813, and further has at least one air-channel portion 817. The air-channel portion 817 is configured in the thermal-dissipating fin 812 and divides the thermal-dissipating fin 812 into two thermal-dissipating parts Z1 and Z2. Hence more air can flow between the thermal-dissipating sheets 81, so as to increase the flow efficiency and enhance the thermal-dissipating effect of the wing-spanning thermal-dissipating device 8.

What is worth to be mentioned is that the number of the configured air-channel portions is not limited. The air-channel portions can also be disposed to divide the thermal-dissipating fin into two or more thermal-dissipating parts, so the thermal-dissipating effect of the wing-spanning thermal-dissipating device can be enhanced.

### Seventh Embodiment: expanded on single side, same sheet, thermal-dissipating sheet having air-channel portion, disposing thermal-dissipating parts interlacedly

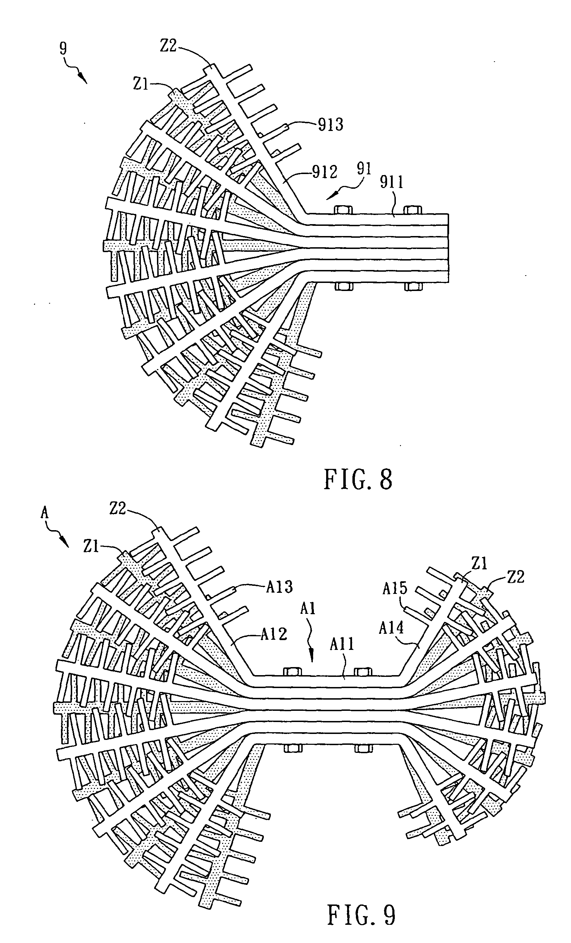

FIG. 8 is a top view of a wing-spanning thermal-dissipating device 9 according to the seventh embodiment of the invention. With reference to FIG. 8, the wing-spanning thermal-dissipating device 9 is made by connecting a plurality of thermal-dissipating sheets 91. Each of the thermal-dissipating sheets 91 includes a connecting portion 911, a thermal-dissipating fin 912 and a plurality of sub-thermal-dissipating fins 913, and further has at least one air-channel portion (not shown). The air-channel portion is configured in and divides the thermal-dissipating fin 912 into two thermal-dissipating parts Z1 and Z2. The thermal-dissipating parts Z1 and Z2 can be disposed interlacedly on a projection plane along a vertical direction. Thus, the flow efficiency of the wing-spanning thermal-dissipating device 9 can be increased and the thermal-dissipating efficiency of the wing-spanning device 9 can be enhanced.

### Eighth Embodiment: expanded on double sides (different sizes on two sides), same sheet, thermal-dissipating sheet having air-channel portion

FIG. 9 is a side view of a wing-spanning thermal-dissipating device A according to the eighth embodiment of the invention. With reference to FIG. 9, the wing-spanning thermal-dissipating device A is made by connecting a plurality of thermal-dissipating sheets A1. Each of the thermal-dissipating sheets A1 includes a connecting portion A11, a thermal-dissipating fin A12, a plurality of sub-thermal-dissipating fins A13 and at least one air-channel portion (not shown). Each of the thermal-dissipating sheets A1 further has another thermal-dissipating fin A14 and a plurality of sub-thermal-dissipating fins A15. The air-channel portion is configured in and divides the thermal-dissipating fins into two thermal-dissipating parts Z1 and Z2. Hence more air can flow between the thermal-dissipating sheets A1, so as to increase the flow efficiency and enhance the thermal-dissipating effect of the wing-spanning thermal-dissipating device A.

In addition, the thermal-dissipating parts Z1 and Z2 can be interlacedly disposed on a projection plane along a vertical direction. Hence the flow efficiency of the wing-spanning thermal-dissipating device A can be increased and the thermal-dissipating effect of the wing-spanning thermal-dissipating device A can be enhanced.

In summary, the wing-spanning thermal-dissipating device of the invention has several sub-thermal-dissipating fins extended from the thermal-dissipating fins. In comparison with the related art, the sub-thermal-dissipating fins provided by the invention can increase the contact area between the thermal-dissipating fins and air, thereby enhancing the thermal-dissipating efficiency.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. A wing-spanning thermal-dissipating device (2; 3; 4; 5; 6; 7; 8; 9) having a plurality of thermal-dissipating sheets (21; 31; 41; 51; 71; 81; 91), each of the thermal-dissipating sheets comprising:
a connecting portion (211; 311; 411; 511; 711; 811; 911), wherein the connecting portions of the thermal-dissipating sheets connect with each other_{;}
at least one thermal-dissipating fin (212; 312; 412; 512; 712; 812; 912), which is expended outwardly and spread out from the connecting portion; and
a plurality of sub-thermal-dissipating fins (213; 313; 413; 513; 713; 813; 913), which are extended from the at least one thermal-dissipating fin;
**characterized in that** the sub-thermal-dissipating fins are disposed asymmetrically on opposite sides of the thermal-dissipating fin, wherein
the sub-thermal-dissipating fins and the adjacent sub-thermal-dissipating fins arc disposed alternately, and
at least one of the sub-thermal-dissipating fins touches against the adjacent thermal-dissipating fin so that the thermal-dissipating fins are spread out from each other.

2. The wing-spanning thermal-dissipating device of claim 1, wherein when each of the thermal-dissipating sheets (31; 41; 51; 71) has a plurality of thermal-dissipating fins (312, 314; 412, 414; 512, 514; 712, 714), the thermal-dissipating fins are extended outwardly from different sides of the connecting portion.

3. The wing-spanning thermal-dissipating device of claim 2, wherein the shapes or sizes of the thermal-dissipating fins are the same or different.

4. The wing-spanning thermal-dissipating device of any of the preceding claims, wherein the sub-thermal-dissipating fins extend perpendicular or non-perpendicular to a surface thereof.

5. The wing-spanning thermal-dissipating device of any of the preceding claims, wherein each of the thermal-dissipating sheets (51) further comprises at least one thermal-dissipating portion (516) extended outwardly from the connecting portion.

6. The wing-spanning thermal-dissipating device of claim 5, wherein the thermal-dissipating portions expand outwardly from each other.

7. The wing-spanning thermal-dissipating device of any of the preceding claims, wherein the connecting portions are connected by screws or rivets.

8. The wing-spanning thermal-dissipating device of any of the preceding claims, wherein the shapes or sizes of adjacent two of the thermal-dissipating sheets are the same or different

9. The wing-spanning thermal-dissipating device of claim 8, wherein the shapes or sizes of the thermal-dissipating fins of adjacent two of the thermal-dissipating sheets are the same or different.

10. The wing-spanning thermal-dissipating device of any of the preceding claims, wherein at least one of the sub-thermal-dissipating fins touch against the adjacent sub-thermal-dissipating fins of an adjacent thermal-dissipating sheet so that the thermal-dissipating fins are spread out from each other.

11. The wing-spanning thermal-dissipating device of any of the preceding claims, wherein each of the thermal-dissipating sheets (812) further comprises:
at least one air-channel portion (817) disposed on the thermal-dissipating fin and dividing the thermal-dissipating fin into at least two thermal-dissipating parts (Z1, Z2).

12. The wing-spanning thermal-dissipating device of claim 11, wherein the thermal-dissipating parts (Z1, Z2) are interlacedly disposed on a projection plane.

## Patentansprüche

1. Flügelumspannende Wärmeableitungsvorrichtung (2; 3; 4; 5; 6; 7; 8; 9) mit einer Mehrzahl von Wärmeableitungsblechen (21; 31; 41; 51; 71; 81; 91), wobei jedes der Wärmeableitungsbleche umfasst:
einen Verbindungsabschnitt (211; 311; 411; 511; 711; 811; 911), wobei die Verbindungsabschnitte der Wärmeableitungsbleche miteinander verbunden sind;
zumindest eine Wärmeableitungsrippe (212; 312; 412; 512; 712; 812; 912), die sich auswärts erstreckt und ausgehend von dem Verbindungsabschnitt aufgespreizt ist; und
eine Mehrzahl von Neben-Wärmeableitungsrippen (213; 313; 413; 513; 713; 813; 913), die sich aufgehend von zumindest einer der Wärmeableitungsrippen erstrecken;
**dadurch gekennzeichnet, dass** die Neben-Wärmeableitungsrippen asymmetrisch auf einander gegenüberliegenden Seiten der Wärmeableitungsrippen vorgesehen sind, wobei
die Neben-Wärmeableitungsrippen und die benachbarten Neben-Wärmeableitungsrippen alternierend angeordnet sind; und
zumindest eine der Neben-Wärmeableitungsrippen die benachbarte Wärmeableitungsrippe berührt, sodass die Wärmeableitungsrippen voneinander weggespreizt sind.

2. Flügelumspannende Wärmeableitungsvorrichtung nach Anspruch 1, wobei, wenn jedes der Wärmeableitungsbleche (31; 41; 51; 71) eine Mehrzahl von Wärmeableitungsrippen (312, 314; 412, 414; 512, 514; 712, 714) aufweist, die Wärmeableitungsrippen sich von unterschiedlichen Seiten des Verbindungsabschnittes aus auswärts erstrecken.

3. Flügelumspannende Wärmeableitungsvorrichtung nach Anspruch 2, wobei die Formen oder Größen der Wärmeableitungsrippen gleich oder unterschiedlichen sind.

4. Flügelumspannende Wärmeableitungsvorrichtung nach einem der vorhergehenden Ansprüche, wobei die Neben-Wärmeableitungsrippen sich senkrecht oder nicht-senkrecht zu deren Oberfläche erstrecken,

5. Flügelumspannende Wärmeableitungsvorrichtung nach einem der vorhergehenden Anspräche, wobei jedes der Wärmeableitungsbleche (51) außerdem zumindest einen Wärmeableitungsabschnitt (516) aufweist, der sich ausgehend von dem Verbindungsabschnitt auswärts erstreckt.

6. Flügelumspannende Wärmeableitungsvorrichtung nach Anspruch 5, wobei die Wärmeableitungsabschnitte sich auswärts voneinander aufweiten.

7. Flügelumspannende Wärmeableitungsvorrichtung nach einem der vorhergehenden Ansprüche, wobei die Verbindungsabschnitte mittels Schrauben oder Nieten miteinander verbunden sind.

8. Flügelumspannende Wärmeableitungsvorrichtung nach einem der vorhergehenden Ansprüche, wobei die Formen oder Größen der Wärmeableitungsbleche gleich oder unterschiedlich sind.

9. Flügelumspannende Wärmeableitungsvorrichtung nach Anspruch 8, wobei die Formen oder Größen der Wärmeableitungsrippen von zwei zueinander benachbarten Wärmeableitungsblechen gleich oder unterschiedlich sind.

10. Flügelumspannende Wärmeableittungsvorrichtung nach einem der vorhergehenden Ansprüche, wobei zumindest eine der Wärmeableitungsrippen die benachbarten Neben-Wärmeableitungsrippen eines benachbarten Wärmeableitungsblechs berührt, sodass die Wärmeableitungsrippen voneinander weggespreizt sind.

11. Flügelumspannende Wärmeableitungsvorrichtung nach einem der vorhergehenden Ansprüche, wobei jedes der Wärmeableitungsbleche (812) außerdem umfässt:
zumindest einen Luftkanalabschnitt (817), der auf der Wärmeableitungsrippe vorgesehen ist und die Wärmeableitungsrippe in zumindest zwei Wärmeableitungstelle (Z1, Z2) unterteilt.

12. Flügelumspannende Wärmeableitungsvorrichtung nach Anspruch 11, wobei die Wärmeableitungsteile (Z1, Z2) auf einer Projektionsebene verschachtelt angeordnet sind.

## Revendications

1. Un dispositif de dissipation thermique en forme d'alle (2 ; 3 ; 4 ; 5 ; 6 ; 7 ; 8 ; 9) disposant d'une pluralité de feuilles de dissipation thermique (21 ; 31 ; 41 ; 51 ; 71 ; 81 ; 91), chacune des feuilles de dissipation thermique comprenant :
une partie de fixation (21 ; 311 ; 411 ; 511 ; 711 ; 811 ; 911) dans laquelle les parties de fixation des feuilles de dissipation thermique se fixent les unes aux autres, au moins une ailette de dissipation thermique (212; 312; 412; 512; 612; 712; 812; 912) s'étendant et se déploient vers l'extérieur depuis les parties de fixation ; et une pluralité de sous-ailettes de dissipation thermique (213 ; 313 ; 413 ; 513 ; 713 ; 813 ; 913) qui s'étendent depuis ladite ailette de dissipation thermique au moins ;
**caractérisé en ce que** les sous-ailettes de dissipation thermique et les sous-ailettes adjacentes de dissipation thermique sont disposées de manière asymétrique sur les côtés opposés des ailettes de dissipation thermique, dans lesquelles,
les sous-ailettes de dissipation thermique et les sous-ailettes adjacentes de dissipation thermique sont disposées en alternance ; et
au moins une des sous-ailettes de dissipation thermique est en contact contre une sous-ailette adjacente de dissipation thermique de telle manière que les ailettes de dissipation thermiques se déploient des unes aux autres.

2. Le dispositif de dissipation thermique en forme d'aile de la revendication 1, dans lequel lorsque chacune des feuilles de dissipation thermique (31; 41; 51; 71) dispose d'une pluralité d'ailettes de dissipation thermique (312; 314; 412; 414; 512; 514; 712; 714), les ailettes de dissipation thermiques s'étendant vers l'extérieur depuis différents cotés de la partie de fixation.

3. Le dispositif de dissipation thermique en forme d'aile de la revendication 2, dans lequel les formes et les dimensions des ailettes de dissipation thermique sont identiques ou différentes.

4. Le dispositif de dissipation thermique en forme d'aile de l'une quelconque des revendications précédentes, dans lequel les sous-ailettes de dissipation thermique s'étendent de manière perpendiculaire ou non à une surface.

5. Le dispositif de dissipation thermique en forme d'aile de l'une quelconque des revendications précédentes, dans lequel chacune des feuilles de dissipation thermique (51) comporte en outre au moins une partie de dissipation thermique (516) s'étendant vers l'extérieur depuis la partie de fixation.

6. Le dispositif de dissipation thermique en forme d'aile de la revendication 5, dans lequel les parties de dissipation thermiques s'éloignent les unes des autres.

7. Le dispositif de dissipation thermique en forme d'aile de l'une quelconque des revendications précédentes, dans lequel les parties de fixation sont fixées au moyen de vis ou de rivets.

8. Le dispositif de dissipation thermique en forme d'aile de l'une quelconque des revendications précédentes, dans lequel les formes et les dimensions de deux feuilles de dissipation thermique adjacentes sont identiques ou différentes.

9. Le dispositif de dissipation thermique en forme d'aile de la revendication 8, dans lequel les formes et les dimensions des ailettes de dissipation thermique de deux feuilles de dissipation thermique adjacentes sont identiques ou différentes.

10. Le dispositif de dissipation thermique en forme d'aile de l'une quelconque des revendications précédentes, dans lequel au moins l'une des sous-ailettes de dissipation thermique est en contact avec une sous-ailette de dissipation thermique adjacente d'une feuille de dissipation thermique adjacente de telle manière que les ailettes de dissipation thermique se déploient les unes par rapport aux autres.

11. Le dispositif de dissipation thermique en forme d'aile de l'une quelconque des revendications précédentes, dans lequel chacune des feuilles de dissipation thermique (812) comporte en outre:
au moins une partie de canal d'air (817) disposée sur l'ailette de dissipation thermique et partageant l'ailette de dissipation thermique en deux parties de dissipation thermique (Z1, Z2).

12. Le dispositif de dissipation thermique en forme d'aile de la revendication 11, dans lequel les parties de dissipation thermique (Z1, Z2) sont disposées de manière entrelacée sur un plan de projection.
